# EUROPÄISCHE PATENTSCHRIFT

(11) **EP 0 829 018 B1**
(45) Veröffentlichungstag und Bekanntmachung des Hinweises auf die Patenterteilung: **02.02.2000**
(21) Anmeldenummer: 96915956.5
(22) Anmeldetag: 31.05.1996
(51) Int. Cl.: G01R 33/09, H01F 13/00

(54) **MAGNETISIERUNGSEINRICHTUNG FÜR EIN MAGNETORESISTIVES DÜNNSCHICHT-SENSORELEMENT MIT EINEM BIASSCHICHTTEIL**
MAGNETIZING ARRANGEMENT FOR A MAGNETO-RESISTIVE THIN-FILM SENSOR ELEMENT WITH A BIAS LAYER PART
DISPOSITIF DE MAGNETISATION POUR ELEMENT DE DETECTION A COUCHE MINCE MAGNETORESISTIVE COMPORTANT UNE PARTIE DE COUCHE DE POLARISATION

(30) Priorität: 01.06.1995 DE 19520172
(43) Veröffentlichungstag der Anmeldung: 18.03.1998
(73) Patentinhaber: SIEMENS AKTIENGESELLSCHAFT, 80333 München (DE)
(72) Erfinder: VAN DEN BERG, Hugo, D-91074 Herzogenaurach (DE)
(86) Internationale Anmeldenummer: DE9600961
(87) Internationale Veröffentlichungsnummer: WO9638738

(56) Entgegenhaltungen:
- FR-A- 2 113 650
- US-A- 4 470 031
- US-A- 4 523 243
- US-A- 4 638 280
- US-A- 5 312 644
- TECHNICAL DIGEST - WESTERN ELECTRIC, Bd. 33, 1.Januar 1974, NEW YORK US, Seiten 23-24, XP002015376 B.G.CASNER: "Wire-wound fixture for magnetizing ferrite carriers"

## Beschreibung

Die Erfindung bezieht sich auf eine Einrichtung mit magnetfelderzeugenden Mitteln zur festen Einprägung einer Magnetisierung in einer vorbestimmten Orientierungsrichtung in wenigstens einer Schicht eines Biasschichtteils eines zugeordneten magnetoresistiven Sensorelementes, das mit einem mehrschichtigen Dünnschichtaufbau auf einem Substrat ausgebildet ist und einen gegenüber einem AMR-Sensorelement erhöhten magnetoresistiven Effekt zeigt. Eine solche Magnetisierungseinrichtung ist in der WO 94/15223 angedeutet.

In Schichten aus ferromagnetischen Übergangsmetallen wie Ni, Fe oder Co und deren Legierungen kann eine Abhängigkeit des elektrischen Widerstandes von der Größe und der Richtung eines das Material durchdringenden Magnetfeldes gegeben sein. Den bei solchen Schichten auftretenden Effekt nennt man anisotropen Magnetowiderstand "AMR" oder anisotropen magnetoresistiven Effekt. Er beruht physikalisch auf den unterschiedlichen Streuquerschnitten von Elektronen mit unterschiedlichem Spin und der Spinpolarität des D-Bandes. Die Elektronen werden deshalb als Majoritäts- bzw. Minoritätselektronen bezeichnet. Für entsprechende magnetoresistive Sensoren wird im allgemeinen eine dünne Schicht aus einem solchen magnetoresistiven Material mit einer Magnetisierung in der Schichtebene vorgesehen. Die Widerstandsänderung bei Drehung der Magnetisierung bezüglich der Stromrichtung kann dann einige Prozent des normalen isotropen (= ohmschen) Widerstandes betragen.

Ferner sind seit einiger Zeit magnetoresistive Mehrschichtensysteme bekannt, welche mehrere, zu einem Stapel angeordnete ferromagnetische Schichten enthalten, die jeweils durch metallische Zwischenschichten voneinander getrennt sind und deren Magnetisierungen jeweils in der Schichtebene liegen. Die Dicken der einzelnen Schichten sind dabei deutlich geringer als die mittlere freie Weglänge der Leitungselektronen gewählt. In solchen Mehrschichtensystemen kann nun zusätzlich zu dem erwähnten anisotropen magnetoresistiven Effekt AMR ein sogenannter giant-magnetoresistiver Effekt oder Giant-Magnetowiderstand GMR auftreten (vgl. z.B. EP-A-0 483 373). Ein solcher GMR-Effekt beruht auf der unterschiedlich starken Streuung von Majoritäts- und Minoritäts-Leitungselektronen an den Grenzflächen zwischen den ferromagnetischen Schichten und den benachbarten Zwischenschichten sowie auf Streueffekten innerhalb der Schichten, insbesondere bei Verwendung von Legierungen. Der GMR-Effekt ist dabei ein isotroper Effekt. Er kann erheblich größer sein als der anisotrope Effekt AMR und Werte bis zu 70 % des normalen isotropen Widerstandes annehmen. In entsprechenden einen GMR-Effekt zeigenden Mehrschichtensystemen sind benachbarte metallische Magnetschichten zunächst entgegengesetzt magnetisiert, wobei eine Biasschicht bzw. ein Biasschichtteil magnetisch härter als eine Meßschicht ist. Unter dem Einfluß eines äußeren Magnetfeldes kann sich dann die anfängliche antiparallele Ausrichtung der Magnetisierungen in eine parallele umwandeln. Bei entsprechenden Magnetfeldsensoren wird diese Tatsache ausgenutzt.

Bei derartigen magnetoresistiven Sensorelementen mit Biasschichtteil wird die erforderliche Einprägung einer Magnetisierung in einer vorbestimmten festen Orientierungsrichtung in dem jeweiligen Biasschichtteil im allgemeinen dadurch bewirkt, daß man das Sensorelement in ein von einem Elektromagneten hervorgerufenes Magnetfeld hinreichender Feldstärke einbringt. Will man aus fertigungstechnischen Gründen gleichzeitig mehrere Sensorelemente in entsprechender Weise magnetisieren, dann ist das nur in einer einzigen Richtung, nämlich in der durch das Feld des Magneten festgelegten Richtung, möglich.

Aus der US 4,638,280 A ist eine Magnetisierungseinrichtung bekannt, mittels derer in einem permanentmagnetischen, beispielsweise plattenhaften Körper aus hochkoerzitivem Material Magnetisierungen in vorbestimmten Orientierungsrichtungen quasi als ein Magnetisierungsmuster mit Multipolkonfiguration in einem Dauerbetrieb einzustellen sind. Hierzu wird ein der Multipolkonfiguration entsprechendes, von einem Dauerstrom durchflossenes Leiterarray vorgesehen, das an dem zu magnetisierenden Körper anliegt. Entsprechende Multipolkonfigurationen sind typisch für permanent erregte Magnetkörper des Rotors einer elektrischen Maschine.

Aufgabe der vorliegenden Erfindung ist es, eine weitere Magnetisierungseinrichtung anzugeben, mit der auf verhältnismäßig einfache Weise die Orientierung der Magnetisierung des Biasschichtteils eines Dünnschicht-Sensorelementes, das einen erhöhten magnetoresistiven Effekt zeigt, einzuprägen ist. Die Einrichtung soll auch so auszugestalten sein, daß auf kleinem Maßstab gleichzeitig mehrere beliebig angeordnete Sensorelemente insbesondere auch mit unterschiedlicher und gegebenenfalls wechselnder Richtung des Einstellfeldes zu magnetisieren sind.

Diese Aufgabe wird für eine Magnetisierungseinrichtung mit den eingangs genannten Merkmalen erfindungsgemäß mit den in Anspruch 1 angegebenen Merkmalen gelöst.

Dabei kann die Orientierung der Magnetisierung in einer einzigen Schicht in eine vorbestimmte Richtung oder in mehreren Schichten in dieselbe Richtung oder in unterschiedliche Richtungen eingeprägt werden.

Die mit dieser Ausgestaltung der Einrichtung verbundenen Vorteile sind insbesondere darin zu sehen, daß mit verhältnismäßig geringem Aufwand in mindestens einem Sensorelement mittels des Einstellstroms durch den dem Sensorelement zugeordneten Leiterbahnteil auch auf engem Raum die Magnetisierung mit vorbestimmter Orientierung in dem Biasschichtteil des Sensorelementes zu "fixieren" ist. Dabei kann der Biasschichtteil sowohl aus einer einzigen, magnetisch härteren Biasschicht als auch aus einem Biasschichtensystem, welches insbesondere auch als ein künstlicher Antiferromagnet (vgl. WO 94/15223) ausgebildet sein kann, bestehen. Die Magnetisierung mehrerer einen Biasschichtteil bildender Schichten kann in den einzelnen Schichten unterschiedlich sein, so daß sich eine entsprechende Magnetisierungsverteilung ergibt. Mit der erfindungsgemäßen Magnetisierungseinrichtung wird also der gegenüber anderen magnetischen Schichten eines Sensorelementes magnetisch härtere Biasschichtteil mittels des von dem jeweiligen Einstellstrom hervorgerufenen Magnetfeldes in vorteilhaft einfacher Weise einmalig in einer vorbestimmten Orientierungsrichtung aufmagnetisiert. Der Einstellstrom ist dabei so hoch zu wählen, daß mit ihm ein für die Aufmagnetisierung des Biasschichtteils hinreichend starkes Magnetfeld zu erhalten ist. Das Magnetfeld des Einstellstromes kann dabei gegebenenfalls von einem äußeren Stütz- und/oder einem besonderen Hilfsfeld überlagert sein. Demgegenüber soll aufgrund der vorbestimmten magnetischen Härte (Koerzitivfeldstärke) des Biasschichtteils eine zu detektierende äußere Magnetfeldkomponente zu einer Ummagnetisierung des Biasschichtteils nicht in der Lage sein.

Vorteilhafte Ausgestaltungen der erfindungsgemäßen Magnetisierungseinrichtung gehen aus den sich dem Hauptanspruch unterordnenden Ansprüchen hervor.

Zur weiteren Erläuterung der Erfindung wird nachfolgend auf die Zeichnung Bezug genommen. Dabei zeigen jeweils schematisch
- Figur 1: einen Querschnitt durch eine Magnetisierungseinrichtung oberhalb eines Sensorelementes,
- Figur 2: eine Schrägansicht auf eine Magnetisierungseinrichtung für mehrere Sensorelemente,
- Figur 3: eine Aufsicht auf die Einrichtung nach Figur 2,
- Figur 4: die Hysteresiskurve eines Biasschichtteils eines Sensorelementes,
- Figur 5: eine Magnetisierungseinrichtung unter Zugrundelegung dieser Hysteresiskurve,
- Figur 6: eine weitere Ausführungsform einer Magnetisierungseinrichtung
und
- Figur 7: eine andere Ausbildungsmöglichkeit einer Magnetisierungseinrichtung.

In den Figuren sind sich entsprechende Teile mit denselben Bezugszeichen versehen.

Die erfindungsgemäße Einrichtung ist zur Einprägung einer vorbestimmten Orientierungsrichtung der Magnetisierung in wenigstens einer Schicht eines Biasschichtteils mindestens eines Sensorelementes vorgesehen.
Das Sensorelement E soll aus einem an sich bekannten magnetoresistiven Mehrschichtensystem, das einen GMR-Effekt zeigt, in Dünnschicht-Technik aufgebaut sein (vgl. z.B. die EP-A-0 483 373 oder die DE-OSen 42 32 244 und 42 43 357 oder die WO 94/15223). Unter einem Schichtaufbau sei hierbei verstanden, daß das Sensorelement eine vorbestimmte Schichtenfolge mit vorbestimmter Dicke der einzelnen Schichten aufweist. Derartige Schichtenfolgen lassen sich vorteilhaft einfach realisieren. Das Sensorelement E weist einen Biasschichtteil mit einer vorbestimmten Orientierungsrichtung der Magnetisierung auf. Ferner enthält es eine gegenüber dem Biasschichtteil magnetisch weichere Meßschicht, die von diesem Biasschichtteil durch eine nicht-magnetische Zwischenschicht getrennt ist.

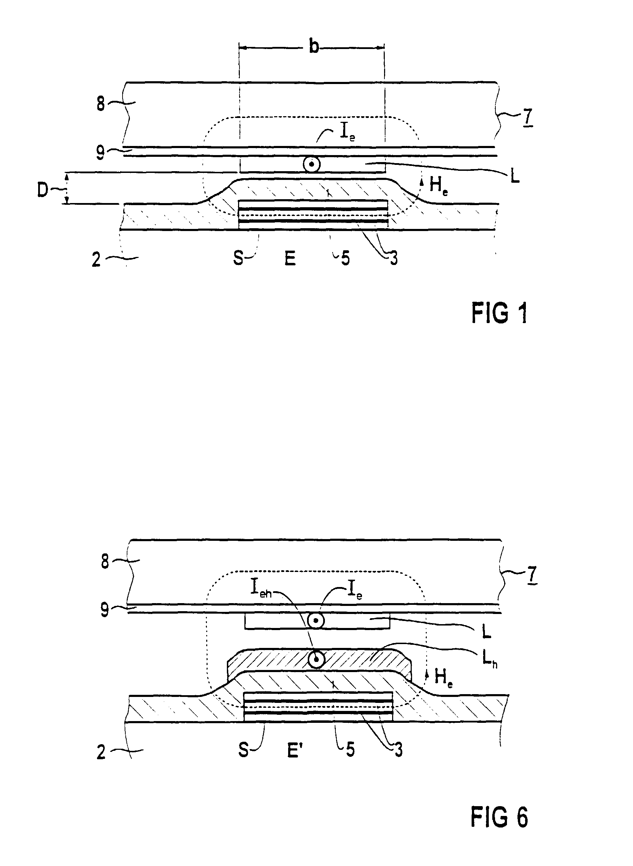

Ein entsprechendes Schichtensystem mit GMR-Effekt kann z.B. das Grundsystem zu einer Ausbildung eines Sensorelementes E sein. Vorzugsweise weist das beispielsweise streifenförmige Sensorelement E eine Vielzahl von entsprechenden magnetischen und nicht-magnetischen Schichten auf. Ein derartiges Mehrschichtensystem sei für das Sensorelement E angenommen, das in Figur 1 angedeutet ist. Sein auf einem Substrat 2 ausgebildetes Mehrschichtensystem S, das beispielsweise einen Biasschichtteil 3 mit mehreren Biasschichten umfaßt, ist mit einer Passivierungsschicht 5 abgedeckt, welche aus einem nicht-magnetischen und insbesondere isolierenden Material besteht. Das Sensorelement E braucht dabei nicht unbedingt mit seinem Mehrschichtensystem eine rechteckige Grundfläche auf dem Substrat 2 einzunehmen. So kann z.B. auch eine Mäanderform vorgesehen werden. Zur Verschaltung des einzelnen Sensorelementes E wird sein GMR-Schichtensystem mit wenigstens zwei Kontakten versehen. Diese Kontakte werden entweder beide auf der obersten elektrisch leitenden Schicht des magnetfeldempfindlichen Schichtensystems angeordnet, so daß ein Strom im Mittel parallel zu den Schichtebenen fließt (sogenanntes "Current-in-Plane (CIP)-System"); oder es wird jeweils ein Kontakt auf der obersten und auf der untersten Schicht angeordnet, so daß dann ein Strom im Mittel senkrecht zu den Schichtebenen fließt (sogenanntes "Current-Perpendicular-to-Plane (CPP)-System". In Figur 1 sind jedoch elektrische Anschlußkontakte an dem Mehrschichtensystem aus Gründen der Übersichtlichkeit weggelassen.

Zu einer Magnetisierung des Biasschichtteils 3 des Sensorelementes E mit vorbestimmter Form seiner Grundfläche und mit einer vorbestimmten Orientierungsrichtung der Magnetisierung ist eine erfindungsgemäße Magnetisierungseinrichtung 7 vorgesehen. Diese Einrichtung kann gemäß Figur 1 einen Leiterbahnträger 8 aufweisen, an dessen dem Sensorelement zugewandter Unterseite ein Leiterbahnteil L aus einem elektrisch gut leitenden Material wie Cu oder Ag angeordnet ist. Gegebenenfalls ist zwischen dem Leiterbahnträger 8 und dem Leiterbahnteil L eine Isolationsschicht 9 vorgesehen. Der Leiterbahnteil L soll vorzugsweise an der dem Sensorelement zugewandten Seite des Leiterbahnträgers 8 so angeordnet sein, daß bei einem Positionieren des Trägers 8 oberhalb des Sensorelementes E der Leiterbahnteil L vorzugsweise zumindest annähernd parallel dem Sensorelement Eⱼ verläuft. Die Leiterbahnbreite b ist im allgemeinen nicht viel größer als die Breite des Schichtensystems S des zugeordneten Sensorelementes E zu wählen. Soll jedoch ein Leiterbahnteil unter einem von Null verschiedenen Winkel bezüglich der Hauptausdehnungsrichtung eines Sensorelementes, beispielsweise unter einem rechten Winkel, verlaufen, dann muß dieser Leiterbahnteil eine solche Breite aufweisen, daß er praktisch vollständig die Fläche des Sensorelementes überdecken kann. Mit einem Einstellstrom Iₑ durch den Leiterbahnteil L läßt sich dann ein magnetisches Einstellfeld Hₑ solcher Richtung und Stärke hervorrufen, daß in dem Biasschichtteil 3 des zugeordneten Mehrschichtensystems S eine Vorzugsrichtung (= Orientierungsrichtung) der Magnetisierung bzw. eine Magnetisierungsverteilung fixierbar ist. Der Einstellstrom kann in Abhängigkeit von dem gewählten Aufbau des Biasschichtteils und den Materialeigenschaften der gewählten Schichten sowohl sein Vorzeichen pro Zeiteinheit der Magnetisierungsdauer wechseln als auch nicht wechseln. D.h., es kann gegebenenfalls auch ein Wechselstrom vorgesehen werden. Für diese Magnetisierung sollte vorzugsweise der Abstand D zwischen einem Leiterbahnteil L und dem Mehrschichtensystem S kleiner als die Leiterbahnbreite b einstellbar sein, da sonst große Stärken des Stromes Iₑ zur Erzeugung der Magnetfelder der Stärke Hₑ erforderlich würden. Im allgemeinen beträgt der Abstand D nur wenige µm. Gegebenenfalls kann der Leiterbahnteil L auch direkt an dem Sensorelement E bzw. dessen Schicht 5 anliegen.

Abweichend von dem gemäß Figur 1 dargestellten Leiterbahnträger 8 sind selbstverständlich auch andere Halterungsmittel zu einer Positionierung mindestens eines Leiterbahnteils an mindestens einem zugeordneten Sensorelement geeignet.

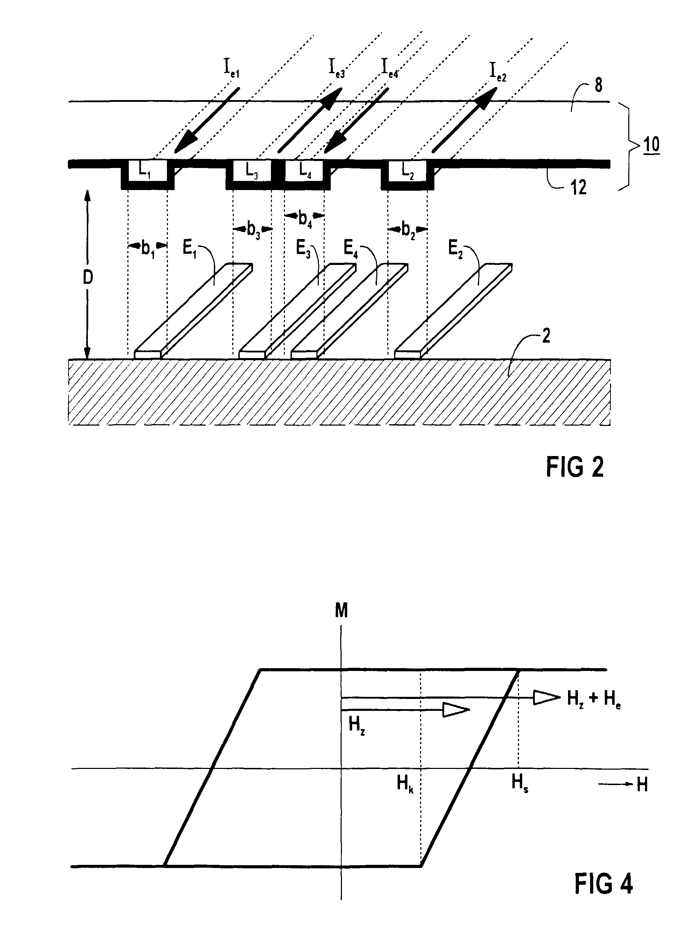

Die erfindungsgemäße Magnetisierungseinrichtung kann vorteilhaft auch so ausgebildet sein, daß mit ihr gleichzeitig mehrere Sensorelemente bezüglich ihrer Biasschichtteile zu magnetisieren sind. Die Sensorelemente sollen sich dabei in beliebiger Anordnung in einer oder mehreren Ebenen auf mindestens einem Substrat befinden können. Ein entsprechendes Ausführungsbeispiel zeigt Figur 2. Die dort allgemein mit 10 bezeichnete Magnetisierungsvorrichtung ist vier GMR-Mehrschichtensensorelementen E₁ bis E₄ zugeordnet, die beispielsweise nebeneinander auf einem gemeinsamen Substrat 2 angeordnet sind. Selbstverständlich können für die Sensorelemente auf dem Substrat auch andere Anordnungsmöglichkeiten gewählt werden. Jedem Sensorelement Eⱼ ist ein Leiterbahnteil Lⱼ (mit 1 ≤ j ≤ 4) an der Unterseite eines Leiterbahnträgers 8 der Magnetisierungseinrichtung 10 zugeordnet. Die Leiterbahnteile Lⱼ können zusätzlich mit einer Isolatorschicht 12 versehen sein, um Kurzschlüsse zwischen benachbarten Leiterbahnteilen auszuschließen. Die Lage der einzelnen Leiterbahnteile Lⱼ an dem Leiterbahnträger 8 ist dabei so gewählt, daß bei einem Heranführen der Magnetisierungseinrichtung 10 an die Sensorelemente Eⱼ die einzelnen Leiterbahnteile Lⱼ genau oberhalb der jeweils zugeordneten Sensorelemente unter Einhaltung eines sehr geringen Abstandes D von im allgemeinen einigen um verlaufen. Die einzelnen Leiterbahnteile L₁ bis L₄ können sich hierzu gegebenenfalls auch in mehreren Ebenen befinden, so daß sich die Leiterbahnen kreuzen können. Sie brauchen sich auch nicht unbedingt parallel zu ihren jeweils zugeordneten Sensorelementen erstrecken. So ist es auch möglich, daß sie mit den Sensorelementen einen Winkel von z.B. 90° einschließen. In diesem Fall müssen die Leiterbahnteile entsprechend breit ausgeführt sein. Gemäß dem in der Figur angedeuteten Ausführungsbeispiel haben sie gleiche Leiterbahnbreiten b₁ bis b₄ und sind von Einstellströmen Iₑ₁ bis Iₑ₄ in den durch Pfeile angedeuteten Stromflußrichtungen durchflossen. Wie aus der Figur ersichtlich ist, können dabei in den einzelnen Sensorelementen vorteilhaft unterschiedliche Biasschichtorientierungen herbeigeführt werden. Die einzelnen Ströme können feste oder gegebenenfalls auch wechselnde Vorzeichen aufweisen.

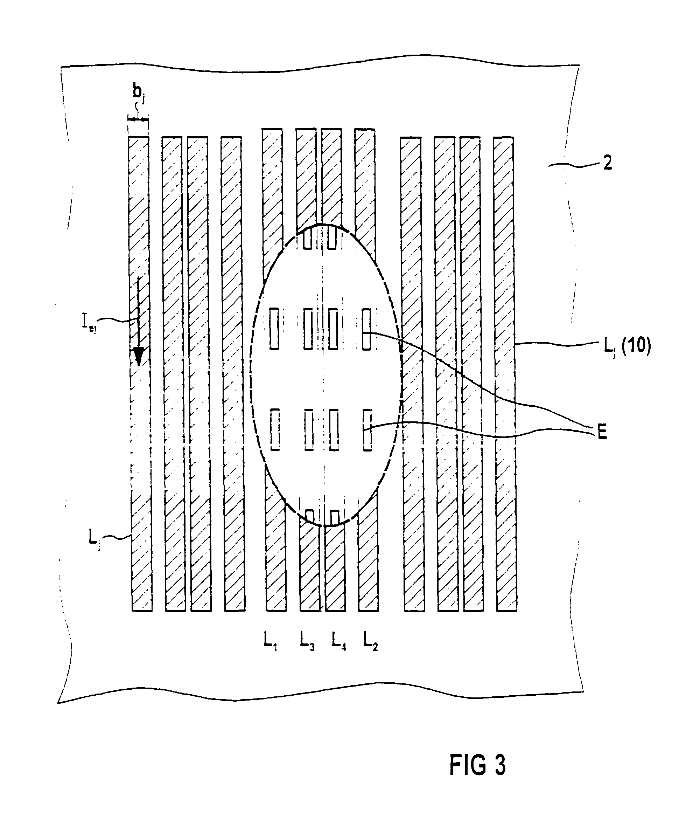

Zu einer wirtschaftlichen Herstellung werden vorteilhaft eine Vielzahl von einzelnen Sensorelementen auf einem gemeinsamen Substrat, beispielsweise einer Siliziumscheibe, gleichzeitig hergestellt. Ein entsprechendes Ausführungsbeispiel ist Figur 3 zugrundegelegt. Die Biasschichtteile der auf einem scheibenförmigen Si-Substrat 2 aufgebrachten GMR-Sensorelement Eⱼ werden mittels hinreichend hoher Einstellströme Iₑⱼ in den jeweils zugeordneten Leiterbahnteilen Lj bzw. L₁ bis L₄ einer erfindungsgemäßen Magnetisierungseinrichtung erzeugt. Dabei können mehrere Leiterbahnteile für mehrere Sensorelemente von durchgehenden Leiterbahnen Lⱼ gebildet werden.

Das von diesen Leiterbahnen hervorzurufende magnetische Einstellfeld Hₑ muß in vielen Fällen verhältnismäßig hoch sein und kann beispielsweise 800 bis 1600 A/cm ( = 1 bis 2 kOe) betragen. Die Stromstärke pro µm der Leiterbahnbreite bⱼ beträgt dann ungefähr 150 bis 300 mA. Für typische Leiterbahnbreite bⱼ von 50 µm ergibt sich dann ein Strom Iₑⱼ von 7 bis 15 A. Ein solch hoher Strom kann zu einer erheblichen Wärmebelastung der Leiterbahn führen. Vorteilhaft wird deshalb die Dicke der Leiterbahnen bzw. ihrer Leiterbahnteile Lⱼ möglichst groß gewählt, weil zum einen der Widerstand und somit auch die Wärmeerzeugung umgekehrt proportional zur Dicke ist und weil zum anderen die Wärmekapazität proportional mit der Dicke zunimmt. Den konkret erreichbaren Leiterbahndicken sind jedoch durch die angewandte Technologie Grenzen gesetzt. Darüber hinaus ist vorteilhaft auch eine Wärmeabfuhr der von den Leiterbahnen erzeugten Wärme mittels Wärmeleitung über den Leiterbahnträger möglich. Dieser Träger sollte deshalb zweckmäßig aus einem thermisch gut leitenden Material bestehen und gegebenenfalls gekühlt werden. Da die Einstellströme verhältnismäßig hoch sind, werden zuverlässige niederohmige Kontakte zwischen einem Stromversorgungsgerät und den Leiterbahnen notwendig. Eine geeignete Bondung oder Lötung von Anschlußdrähten an den Leiterbahnträger läßt sich im Hinblick auf eine vorteilhafte Mehrfachnutzung jeder Leiterbahnkonfiguration durchführen.

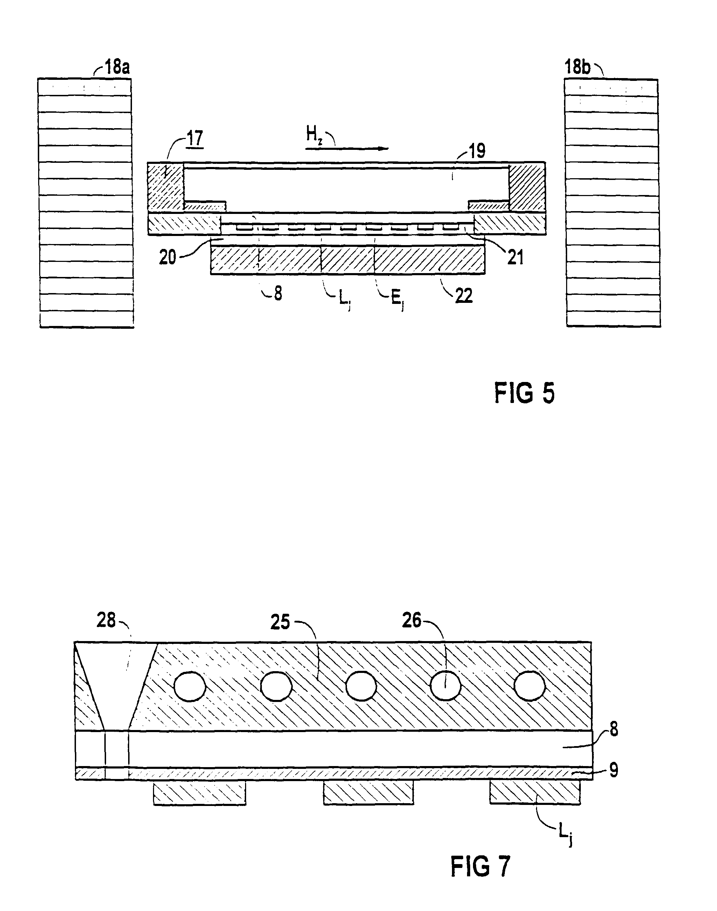

Eine weitere Möglichkeit zu einer Erniedrigung des Einstellstromes in einer Leiterbahn besteht darin, daß man zusätzlich ein äußeres Stützfeld der Stärke H_{z} anlegt. Dieses Stützfeld soll parallel oder antiparallel zu dem von dem jeweiligen Leiterbahnteil hervorgerufenen Einstellfeld Hₑ gerichtet sein. Das Stützfeld H_{z} und das Einstellfeld Hₑ ermöglichen dann ein notwendiges Überschreiten eines vorbestimmten Schwellwertes der Feldstärke des Magnetfeldes, dem sich der Biasschichtteil des GMR-Mehrschichtensystems ausgesetzt sieht. Entsprechende Feldverhältnisse, wie sie für eine Biasschicht oder für ein System eines künstlichen Antiferromagneten (vgl. DE-OS 42 43 358) typisch sind, gehen aus dem Diagramm der Figur 4 hervor. In diesem Diagramm sind jeweils in willkürlichen Einheiten in Richtung der Abszisse die Feldstärke H und in Richtung der Ordinate die Magnetisierung M aufgetragen. Für die dargestellte Hysteresiskurve stellen die Größen Hₛ eine Schwellwertfeldstärke, die gemäß dem angenommenen Ausführungsbeispiel die Sättigungsfeldstärke sein kann, ferner H_{c} die Koerzitivfeldstärke und Hₖ die Feldstärke dar, bei der sich die Magnetisierung M vom Wert der negativen Sättigungsmagnetisierung mit zunehmender Feldstärke sprunghaft zu erhöhen beginnt. H_{z} wird ungefähr gleich (Hₖ + Hₛ)/2 gewählt. Die Summe der Beträge von H_{z} und dem Einstellfeld Hₑ ist größer als die Sättigungsfeldstärke Hₛ, während ||H_{z}| - |Hₑ|| kleiner als Hₖ ist. H_{z} und Hₑ sind dabei parallel gerichtet. Die Richtung von H_{z} kann zur Einstellung auch umgekehrt werden. Dementsprechend wären in einer ersten Einstellphase Hₑ und H_{z} an den Leiterbahnen L₁ und L₄ (gemäß Figur 2) gleich gerichtet, und es wird in den entsprechenden Sensorelementen E₁ und E₄ die Biasschichtmagnetisierung eingestellt. In den anderen Elementen E₂ und E₃ herrscht hingegen ein Feld |H_{z}| - |Hₑ|, das zu gering ist, um die Biasschichtmagnetisierungen in diesen Elementen zu beeinträchtigen. Bei entgegengesetztem H_{z} vertauschen sich die Rollen der Elementpaare E₁-E₄ und E₂-E₃, so daß die Elemente E₂ und E₃ dann in die Gegenrichtung magnetisiert werden. Für den Fall, daß Hₖ =Hₛ/2 ist und Hₑ ≈ 1,1 *(Hₛ-Hₖ)/2 ist, reduziert sich die Einstellstromstärke um einen Faktor 1,1:4. Bei gleicher Leiterbahngeometrie ist dann die erzeugte Wärme um einen Faktor 1:9 geringer.

Bei einigen Mehrschichtensystemen, insbesondere sogenannten "Exchange-Biased-Systemen" mit Biasschichtteil aus einer Ni-Fe-Schicht mit FeMn-Unterlage (vgl. z.B. EP-A-0 346 817), kann es vorteilhaft sein, das Schichtensystem während der Magnetisierung seines Biasschichtteils erhöhten Temperaturen auszusetzen. So ist z.B. für die erwähnte FeMn-Schicht des Schichtensystems eine Temperaturerhöhung auf etwa 150°C günstig. Eine entsprechende Temperaturerhöhung kann durch Anordnung des Schichtensystems in einem geheizten Raum erfolgen.

Gemäß dem dem Diagramm der Figur 4 zugeordneten Ausführungsbeispiel wurde davon ausgegangen, daß ein äußeres magnetisches Stütz feld mit einer solchen Feldstärke H_{z} gewählt wird, daß mit ihm allein die Schwellwertfeldstärke Hₛ nicht zu überschreiten ist. Selbstverständlich ist es auch möglich, ein entsprechend hohes magnetisches Stütz feld vorzusehen und dann mit dem Einstellfeld einer Leiterbahn der erfindungsgemäßen Magnetisierungseinrichtung ein Gegenfeld aufzubauen, das das Stützfeld entsprechend vermindert.

Figur 5 zeigt die wesentlichen Teile einer erfindungsgemäßen Einrichtung zur Einprägung der Biasschichtmagnetisierung von mehreren GMR-Sensorelementen. Der Aufbau dieser allgemein mit 17 bezeichneten Einrichtung ähnelt dem von bekannten optischen Kontaktbelichtungsanlagen, die in der Mikrostrukturtechnik Anwendung finden. Auf die Unterscheidungsmerkmale der erfindungsgemäßen Magnetisierungseinrichtung gegenüber diesen bekannten Anlagen sei nachfolgend eingegangen. Dabei sind in der Figur bezeichnet mit 18a und 18b eine magnetische Feldquelle, mit 19 eine Kühlungskammer, mit 20 ein Sensorsubstrat mit darauf befindlichen, in der Figur nur angedeuteten GMR-Sensorelementen Eⱼ, mit 21 ein entlüftbarer Zwischenraum und mit 22 eine Einrichtung zur Positionierung des Sensorsubstrats 20 bezüglich eines Leiterbahnträgers 8 mit Leiterbahnen Lⱼ. Als Feldquelle zur Erzeugung des Zusatzfeldes H_{z} können gemäß dem dargestellten Ausführungsbeispiel Dauermagnete 18a und 18b vorgesehen werden, zwischen deren Magnetpolen die Leiterbahnen Lⱼ und die zugeordneten Sensorelemente Eⱼ verlaufen. Eine Feldumkehrung kann z.B. durch Drehung des gesamten Magnetsystems um eine Achse senkrecht zum Feld der Leiterbahnen Lⱼ erfolgen. Man kann aber auch zwei getrennte Magnetfeldbereiche mit entgegengesetzten Feldrichtungen vorsehen, in die der Aufbau mit dem Leiterbahnträger und dem Sensorsubstrat nacheinander eingebracht werden. Selbstverständlich sind zur Erzeugung des Feldes H_{z} auch elektrische Magnetfeldspulen geeignet, die beispielsweise den Leiterbahnträger und das zugeordnete Sensorsubstrat umschließen.

Als weitere Maßnahme zur Reduzierung des Einstellstromes Iₑ in der mindestens einen Leiterbahn ist es möglich, an oder in dem wenigstens einen zu magnetisierenden Sensorelement ein Teilstück mindestens einer Hilfsleiterbahn vorzusehen, um damit einen Teil des zur Magnetisierung des wenigstens einen Biasschichtteils erforderlichen Magnetfeldes zu erzeugen. Ein entsprechendes Ausführungsbeispiel zeigt Figur 6, wobei von einer Ausführungsform nach Figur 1 ausgegangen ist. Das gezeigte Sensorelement E' unterscheidet sich von dem Sensorelement E nach Figur 1 praktisch nur dadurch, daß es z.B. an seiner dem Leiterbahnteil L der Magnetisierungseinrichtung 7 zugewandten Seite einen Hilfsleiterbahnteil Lₕ aus elektrisch gut leitendem Material aufweist, über den ein vorbestimmter Hilfseinstellstrom Iₑₕ zu führen ist. Somit können von dem Leiterbahnteil L und dem Hilfsleiterbahnteil Lₕ sich zu einem Magnetfeld der Stärke Hₑ überlagernde Teilfelder erzeugt werden, um die vorbestimmten Magnetisierungsverhältnisse in dem Biasschichtteil 3 des Sensorelementes E' zu erreichen. Die Ströme Iₑ und Iₑₕ brauchen dabei nicht unbedingt vom gleichen Typ bezüglich eines Vorzeichenwechsels zu sein. So kann z.B. für den Leiterbahnteil L ein Gleichstrom und für den Hilfsleiterbahnteil Lₕ ein Wechselstrom vorgesehen werden.

Selbstverständlich ist es auch möglich, die in Figur 6 angedeutete Ausführungsform einer erfindungsgemäßen Magnetisierungseinrichtung mit den ein magnetisches Stützfeld erzeugenden Maßnahmen gemäß den Figuren 4 und 5 zu kombinieren.

Bei einer erfindungsgemäßen Magnetisierungseinrichtung kann es ferner zweckmäßig sein, gemäß Figur 5 einen entlüftbaren Zwischenraum 21 vorzusehen, um den Abstand zwischen einem Sensorsubstrat 20 und einem Leiterbahnträger 8 über der ganzen Kontaktfläche genügend gering halten zu können. Zur Unterdruckerzeugung wird beispielsweise die Luft aus dem Zwischenraum abgesaugt. Es sind so die Anforderungen für den Leiterbahnträger-Sensorsubstrat-Abstand D verhältnismäßig leicht zu erfüllen, wobei D in der Größenordnung von 10 µm liegt. Nur bei Sensorelementen mit sehr kleinen lateralen Abmessungen und bei unebenen Sensorsubstraten können Probleme auftreten. In diesem Fall sind flexible Träger und/oder Sensorsubstrate anwendbar. Der Unterdruck in dem Zwischenraum 21 sorgt dann dafür, daß der Leiterbahnträger und das Sensorsubstrat sich gegenseitig in ihrer Form anpassen.

Darüber hinaus ist vorteilhaft eine Kühlung des Leiterbahnträgers 8 möglich. Gemäß Figur 5 kann hierzu der Kühlungsraum 19 dienen, durch den ein flüssiges oder gasförmiges Kühlmedium geführt werden kann. Zusätzlich oder stattdessen ist auch ein Kühlkörper mit einer großen Wärmekapazität zur Wärmeabfuhr geeignet. Ein entsprechendes Ausführungsbeispiel zeigt Figur 7. Dementsprechend ist an einen Leiterbahnträger 8 auf dessen seinen mehreren Leiterbahnen Lⱼ abgewandter Seite ein Kühlkörper 25 angesetzt, der zusätzlich noch mit Kühlkanälen 26 zur Führung eines Kühlmittels versehen sein kann. Wie aus der Figur ferner zu entnehmen ist, weist der Kühlkörper 25 ein Justierloch 28 auf. Damit ist eine optische Justierung des Kühlkörpers bzw. seiner mit ihm verbundenen Leiterbahnen bezüglich einer entsprechenden Markierung auf der Oberfläche eines Sensorsubstrates möglich. Ähnliche optische Verfahren werden in der Mikrostrukturtechnik eingesetzt, um eine meistens durchsichtige Kontaktmaske bezüglich eines Wafers zu positionieren. Wegen des im allgemeinen nichttransparenten Leiterbahnträgers 8 und des Kühlkörpers 25 wird hier das Justierloch 28 erforderlich. Die Positioniergenauigkeit braucht hier nicht die in der Mikrostrukturtechnik üblichen Forderungen zu erfüllen. Deswegen kommen auch andere nicht-optische Verfahren wie z.B. elektrische Kontakte zur Justierung in Frage.

## Patentansprüche

1. Einrichtung mit magnetfelderzeugenden Mitteln zur festen Einprägung einer Magnetisierung in einer vorbestimmten Orientierungsrichtung in wenigstens einer Schicht eines Biasschichtteils eines zugeordneten magnetoresistiven Sensorelementes, das mit einem mehrschichtigen Dünnschichtaufbau auf einem Substrat ausgebildet ist und einen gegenüber einem AMR-Sensorelement erhöhten magnetoresistiven Effekt zeigt, **gekennzeichnet**
- durch mindestens einen elektrisch leitenden Leiterbahnteil (L, Lⱼ), der eine solche Breite (b, bⱼ) aufweist, daß von ihm die Fläche der wenigstens einen zu magnetisierenden Schicht des Biasschichtteils (3) des zugeordneten Sensorelementes (E, E', Eⱼ) zumindest annähernd überdeckt wird, wobei für die Einprägung der Magnetisierung der Abstand (D) zwischen dem Leiterbahnteil (L, Lⱼ) und dem mehrschichtigen Dünnschichtaufbau kleiner als die Breite (b, bⱼ) des Leiterbahnteils (L, Lⱼ) einstellbar ist,
- durch Mittel zu einer Positionierung des Leiterbahnteils (L, Lⱼ) bezüglich des Sensorelementes (E, E', Eⱼ)
und
- durch Mittel zur Führung eines vorbestimmten Einstellstromes (Iₑ, Iₑⱼ) in dem Leiterbahnteil (L, Lⱼ) derart, daß zumindest ein Teil eines Magnetfeldes (Hₑ) zu erzeugen ist, mittels dessen in der wenigstens einen zu magnetisierenden Schicht des Biasschichtteils (3) des zugeordneten Sensorelementes (E, E', Eⱼ) die die vorbestimmte Orientierungsrichtung aufweisende Magnetisierung einmalig fest einstellbar ist.

2. Einrichtung nach Anspruch 1, **gekennzeichnet** durch einen einzigen Leiterbahnteil (L, Lⱼ), der mehreren Sensorelementen (Eⱼ) zuzuordnen ist.

3. Einrichtung nach Anspruch 1, **gekennzeichnet** durch mehrere Leiterbahnteile (L, Lⱼ), die mehreren Sensorelementen (Eⱼ) zuzuordnen sind.

4. Einrichtung nach einem der Ansprüche 1 bis 3, **dadurch gekennzeichnet**, daß der mindestens eine Leiterbahnteil (L, Lⱼ) unter einem von Null verschiedenen Winkel bezüglich der Hauptausdehnungsrichtung des wenigstens einen zugeordneten Sensorelementes (E, E', Eⱼ) anzuordnen ist.

5. Einrichtung nach einem der Ansprüche 1 bis 4, **dadurch gekennzeichnet**, daß Mittel zur Einstellung erhöhter Temperaturen bei der Magnetisierung des Biasschichtteils (3) des wenigstens einen Sensorelementes (E, , E', Eⱼ) vorgesehen sind.

6. Einrichtung nach einem der Ansprüche 1 bis 5 **gekennzeichnet** durch einen in dem Leiterbahnteil (L, Lⱼ) fließenden Einstellstrom (Iₑ), dessen Vorzeichen pro Zeiteinheit wechselt.

7. Einrichtung nach einem der Ansprüche 1 bis 6, **dadurch gekennzeichnet**, daß der mindestens eine Leiterbahnteil (L, Lⱼ) aus einem elektrisch gut leitenden Material besteht.

8. Einrichtung nach einem der Ansprüche 1 bis 7, **dadurch gekennzeichnet**, daß der mindestens eine Leiterbahnteil (L, Lⱼ) an einem Leiterbahnträger (8) befestigt ist.

9. Einrichtung nach Anspruch 8, **dadurch gekennzeichnet**, daß der Leiterbahnträger (8) aus einem thermisch gut leitenden Material besteht zur Wärmeabfuhr der von dem mindestens einen Leiterbahnteil (L, Lⱼ) erzeugten Wärme mittels Wärmeleitung über den Leiterbahnträger.

10. Einrichtung nach Anspruch 8 oder 9, **dadurch gekennzeichnet**, daß Mittel zur Kühlung des Leiterbahnträgers (8) vorgesehen sind.

11. Einrichtung nach Anspruch 10, **dadurch gekennzeichnet**, daß der Leiterbahnträger auf seiner den Leiterbahnteilen abgewandten Seite mit einem Kühlkörper (25) mit Kühlkanälen (26) für ein Kühlmittel verbunden ist.

12. Einrichtung nach einem der Ansprüche 8 bis 11, **dadurch gekennzeichnet**, daß Mittel zur Justierung des Leiterbahnträgers (8) oberhalb des mindestens einen Sensorelementes (E, , E', Eⱼ) vorgesehen sind.

13. Einrichtung nach einem der Ansprüche 1 bis 12, **dadurch gekennzeichnet**, daß allein mittels des Einstellstromes (Iₑ) in dem Leiterbahnteil (L, Lⱼ), der dem wenigstens einen Sensorelement (E, E', Eⱼ) zugeordnet ist, die vorbestimmte Orientierungsrichtung der Magnetisierung des Biasschichtteils auszubilden ist.

14. System mit einer Einrichtung nach einem der Ansprüche 1 bis 12, **dadurch gekennzeichnet**, daß mit dem wenigstens einen Sensorelement (E') mindestens ein elektrisch leitender Hilfsleiterbahnteil (Lₕ) fest verbunden ist und daß mittels eines vorbestimmten Hilfseinstellstromes (Iₑₕ) in diesem Hilfsleiterbahnteil (Lₕ) ein Teil des zur Magnetisierung des Biasschichtteils (3) erforderlichen Magnetfeldes zu erzeugen ist.

15. System mit einer Einrichtung nach einem der Ansprüche 1 bis 12 oder System nach Anspruch 14, **dadurch gekennzeichnet**, daß das wenigstens eine Sensorelement (Eⱼ) einem von einer magnetischen Feldquelle (18a, 18b) hervorgerufenen Stützfeld solcher Stärke (H_{z}) auszusetzen ist, daß dieses Stützfeld einen Teil des zur Magnetisierung des Biasschichtteiles (3) erforderlichen Magnetfeldes bildet.

## Claims

1. Device with magnetic-field-generating means for the fixed setting of a magnetization in a predetermined orientation direction in at least one layer of a bias layer part of an allocated magnetoresistive sensor element, which is constructed with a multilayer thin-layer construction on a substrate and displays a magnetoresistive effect which is increased compared with an AMR sensor element, characterized
- by at least one electroconductive printed conductor part (L, Lⱼ) which has such a width (b, bⱼ) that it covers at least approximately the surface of the at least one layer of the bias layer part (3) of the allocated sensor element (E, E', Eⱼ), which layer is to be magnetized, wherein for the setting of the magnetization the distance (D) between the printed conductor part (L, Lⱼ) and the multilayer thin-layer construction can be adjusted to be smaller than the width (b, bⱼ) of the printed conductor part (L, Lⱼ),
- by means for a positioning of the printed conductor part (L, Lⱼ) with respect to the sensor element (E, E', Eⱼ)
and
- by means for carrying a predetermined set current (Iₑ, Iₑⱼ) in the printed conductor part (L, Lⱼ) in such a way that at least a part of a magnetic field (Hₑ) is to be generated, by means of which, in the at least one layer of the bias layer part (3) of the allocated sensor element (E, E', Eⱼ), which layer is to be magnetized, the magnetization having the predetermined orientation direction can be firmly adjusted once.

2. Device according to claim 1, characterized by a single printed conductor part (L, Lⱼ) which is to be allocated to several sensor elements (Eⱼ).

3. Device according to claim 1, characterized by several printed conductor parts (L, Lⱼ) which are to be allocated to several sensor elements (Eⱼ).

4. Device according to one of claims 1 to 3, characterized in that the at least one printed conductor part (L, Lⱼ) is to be arranged at an angle different to zero with respect to the main extension direction of the at least one allocated sensor element (E, E', Eⱼ).

5. Device according to one of claims 1 to 4, characterized in that means are provided for the setting of increased temperatures in the magnetization of the bias layer part (3) of the at least one sensor element (E, E', Eⱼ).

6. Device according to one of claims 1 to 5, characterized by a set current (Iₑ) flowing in the printed conductor part (L, Lⱼ), the sign of which set current changes per time unit.

7. Device according to one of claims 1 to 6, characterized in that the at least one printed conductor part (L, Lⱼ) consists of a material of good electroconductivity.

8. Device according to one of claims 1 to 7, characterized in that the at least one printed conductor part (L, Lⱼ) is secured to a printed conductor carrier (8).

9. Device according to claim 8, characterized in that the printed conductor carrier (8) consists of a material of good thermal conductivity for the removal of the heat generated by the at least one printed conductor part (L, Lⱼ) by means of heat conduction by way of the printed conductor carrier.

10. Device according to claim 8 or 9, characterized in that means are provided for cooling the printed conductor carrier (8).

11. Device according to claim 10, characterized in that the printed conductor carrier is connected on its side directed away from the printed conductor parts to a cooling body (25) with cooling channels (26) for a coolant.

12. Device according to one of claims 8 to 11, characterized in that means are provided for the adjustment of the printed conductor carrier (8) above the at least one sensor element (E, E', Eⱼ).

13. Device according to one of claims 1 to 12, characterized in that the predetermined orientation direction of the magnetization of the bias layer part is to be formed only by means of the set current (Iₑ) in the printed conductor part (L, Lⱼ), which is allocated to the at least one sensor element (E, E', Eⱼ).

14. System with a device according to one of claims 1 to 12, characterized in that at least one electroconductive auxiliary printed conductor part (Lₕ) is firmly connected to the at least one sensor element (E') and in that a part of the magnetic field necessary for the magnetization of the bias layer part (3) is to be generated by means of a predetermined auxiliary set current (Iₑₕ) in this auxiliary printed conductor part (Lₕ).

15. System with a device according to one of claims 1 to 12 or system according to claim 14, characterized in that the at least one sensor element (Eⱼ) is to be exposed to a supporting field, generated by a magnetic field source (18a, 18b), of such an intensity (H_{z}) that this supporting field forms a part of the magnetic field necessary for the magnetization of the bias layer part (3).

## Revendications

1. Dispositif comportant des moyens pour créer un champ magnétique permettant l'impression permanente d'une magnétisation, dans une direction d'orientation prédéfinie, dans au moins une couche d'une partie de couche de polarisation d'un élément de détection magnétorésistif associé, qui est réalisé avec une structure à couches minces multiples sur un substrat et qui manifeste un effet magnétorésistif accru par rapport à un élément de détection AMR, caractérisé
- par au moins une partie de piste conductive (L, Lⱼ) électroconductrice ayant une telle largeur (b, bⱼ) qu'elle recouvre au moins approximativement la surface de la - au moins - une couche à magnétiser de la partie de couche de polarisation (3) de l'élément de détection (E, E', Eⱼ) associé, la distance (D) entre la partie de piste conductive (L, Lⱼ) et la structure à couches minces multiples, pour imprimer la magnétisation, étant réglable de manière à être inférieure à la largeur (b, bj) de la partie de piste conductive (L, Lⱼ) ;
- par des moyens pour positionner la partie de piste conductive (L, Lⱼ) par rapport à l'élément de détection (E, E', Eⱼ)
et
- par des moyens pour conduire un courant de réglage (Iₑ, Iₑⱼ) prédéfini dans la partie de piste conductive (L, Lⱼ), de manière à créer au moins une partie d'un champ magnétique (Hₑ), permettant de régler de façon permanente, en une fois, dans la - au moins - une couche à magnétiser de la partie de couche de polarisation (3) de l'élément de détection (E, E', Eⱼ) associé, la magnétisation présentant la direction d'orientation prédéfinie.

2. Dispositif selon la revendication 1, caractérisé par une unique partie de piste conductive (L, Lⱼ) à associer à plusieurs éléments de détection (Eⱼ).

3. Dispositif selon la revendication 1, caractérisé par plusieurs parties de piste conductive (L, Lⱼ) à associer à plusieurs éléments de détection (Eⱼ).

4. Dispositif selon l'une des revendications 1 à 3, caractérisé en ce que la - au moins - une partie de piste conductive (L, Lⱼ) est à placer sous un angle différent de zéro par rapport au sens d'extension principal du - au moins - un élément de détection (E, E', Eⱼ) associé.

5. Dispositif selon l'une des revendications 1 à 4, caractérisé en ce que des moyens sont prévus permettant le réglage de températures plus élevées lors de la magnétisation de la partie de couche de polarisation (3) du - au moins - un élément de détection (E, E', Eⱼ).

6. Dispositif selon l'une des revendications 1 à 5, caractérisé par un courant de réglage (lₑ) dans la partie de piste conductive (L, Lⱼ), dont le signe change par unité de temps.

7. Dispositif selon l'une des revendications 1 à 6, caractérisé en ce que la - au moins - une partie de piste conductive (L, Lⱼ) est constituée d'un matériau de bonne conductivité électrique.

8. Dispositif selon l'une des revendications 1 à 7, caractérisé en ce que la - au moins - une partie de piste conductive (L, Lⱼ) est fixée sur un support de piste conductive (8).

9. Dispositif selon la revendication 8, caractérisé en ce que le support de piste conductive (8) est constitué d'un matériau de bonne conductivité thermique pour dissiper la chaleur produite par la - au moins - une partie de piste conductive (L, Lⱼ) par conduction de chaleur via le support de piste conductive.

10. Dispositif selon la revendication 8 ou 9, caractérisé en ce que des moyens de refroidissement du support de piste conductive (8) sont prévus.

11. Dispositif selon la revendication 10, caractérisé en ce que le support de piste conductive, sur son côté opposé aux parties de piste conductive, est relié à un corps de refroidissement (25) comportant des canaux de refroidissement (26) pour un agent réfrigérant.

12. Dispositif selon l'une des revendications 8 à 11, caractérisé en ce que des moyens sont prévus permettant d'ajuster le support de piste conductive (8) au-dessus du - au moins - un élément de détection (E, E', Eⱼ).

13. Dispositif selon l'une des revendications 1 à 12, caractérisé en ce que seul le courant de réglage (lₑ) dans la partie de piste conductive (L, Lⱼ) associée au - au moins - un élément de détection (E, E', Eⱼ) sera utilisé pour réaliser la direction d'orientation prédéfinie de la magnétisation de la partie de couche de polarisation.

14. Système comportant un dispositif selon l'une des revendications 1 à 12, caractérisé en ce que le - au moins - un élément de détection (E') est solidaire d'au moins une partie de piste conductive auxiliaire (Lₕ) et en ce qu'au moyen d'un courant de réglage auxiliaire (Iₑₕ) prédéfini dans cette partie de piste conductive auxiliaire (Lₕ), une partie du champ magnétique nécessaire à la magnétisation de la partie de couche de polarisation (3) est à créer.

15. Système comprenant un dispositif selon l'une des revendications 1 à 12 ou système selon la revendication 14, caractérisé en ce que le - au moins - un élément de détection (Eⱼ) est à exposer à un champ support provoqué par une source de champ magnétique (18a, 18b) et ayant une telle force (H_{z}) que ce champ support forme une partie du champ magnétique nécessaire à la magnétisation de la partie de couche de polarisation (3).
